# EUROPÄISCHE PATENTSCHRIFT

(11) **EP 4 105 588 B1**
(45) Veröffentlichungstag und Bekanntmachung des Hinweises auf die Patenterteilung: **05.08.2026**
(21) Anmeldenummer: 21179471.4
(22) Anmeldetag: 15.06.2021
(51) Int. Cl.: F28F 1/40, F28F 13/12, H05K 7/20, H10W 40/47, F28F 3/02

(54) **KÜHLKÖRPER**
COOLING ELEMENT
DISSIPATEUR THERMIQUE

(43) Veröffentlichungstag der Anmeldung: 21.12.2022
(73) Patentinhaber: Materials Center Leoben Forschung GmbH, 8700 Leoben (AT)
(72) Erfinder: Lohrasbi, Sina, 8010 Graz (AT); Hammer, René, 8010 Graz (AT); Eßl, Werner, 8700 Leoben (AT); Reiss, Georg, 8700 Leoben (AT)
(74) Vertreter: Wirnsberger & Lerchbaum Patentanwälte OG

(56) Entgegenhaltungen:
- WO-A1-97/46846
- AU-A1- 2015 339 717
- US-A1- 2011 094 721
- US-A1- 2016 370 128
- US-A1- 2019 030 503
- US-A1- 2020 326 141

## Beschreibung

Die Erfindung betrifft einen Kühlkörper, aufweisend eine oder mehrere Begrenzungen, welche ein Volumen definieren, das von einem Kühlmedium entlang einer Strömungsrichtung durchströmbar ist, und zumindest eine im Volumen angeordnete Struktur, welche ausgelegt ist, das Kühlmedium beim Durchströmen des Volumens umzulenken. Ein derartiger Kühlkörper mit den Merkmalen des Oberbegriffs des Anspruchs 1 ist aus der AU 2015 339 717 bekannt.

Des Weiteren betrifft die Erfindung eine Verwendung eines derartigen Kühlkörpers.

Das Wärmemanagement spielt bei Hochleistungsapplikationen im Elektroniksektor eine wichtige Rolle. Höhere Leistungen und damit in der Regel auch höhere Abwärme erfordern auch leistungsfähigere Kühlkörper, um unerwünschter Erhitzung und damit einem möglichen Schadensfall vorzubeugen.

Aus dem Stand der Technik sind verschiedene Konzepte für Kühlkörper bekannt geworden, in welchen ein Kühlmedium zum Wärmeabtransport führbar ist, wobei eine innere Struktur des jeweiligen Kühlkörpers so ausgelegt ist, dass ein möglichst guter Wärmetransport erzielt wird. Hierzu zählen beispielsweise sogenannte Pin-Fin-Kühlkörper mit einer inneren Struktur, die von aufragenden Pins geprägt ist.

Andere Konzepte sehen beispielsweise vor, bei einem Wärmetauscher Turbulenzen oder Wirbel zu erzeugen, um so einen möglichst guten Wärmeabtransport zu erzielen. Hierfür werden Strukturen im Inneren eines Gehäuses oder dergleichen vorgesehen, in welchen das Kühlmedium geführt wird. Je nach Überlegungen können die Strukturen unterschiedlich ausgebildet sein. Konzepte dieser Art sind beispielsweise entnehmbar aus DE 10 2007 036 305 A1, DE 295 16 927 U1, EP 2 770 290 A1, EP 3 524 916 A1, WO 2014/188942 A1 oder CN 206755963 U.

Wenngleich die bekannten Konzepte im Vergleich mit im Inneren strukturlosen Volumina für das geführte Kühlmedium durchaus Vorteile erbringen mögen, ist eine Kühlleistung für viele Anwendungen auch bei gegebenen Turbulenzen zu gering. Ein anderes Problem resultiert bei Kühlkörpern der eingangs genannten Art oftmals darin, dass bei einer erforderlichen Kühlleistung ein Druckabfall entlang einer Konvektionsstrecke zu groß werden kann bzw. zu viel Gegendruck für das Kühlmedium gegeben ist.

Hier setzt die Erfindung an. Aufgabe der Erfindung ist es, einen Kühlkörper der eingangs genannten Art anzugeben, welcher eine hohe Kühlleistung ermöglicht und bei dem gleichzeitig kein unerwünscht hoher Druckabfall auftritt.

Diese Aufgabe wird durch einen Kühlkörper gemäß Anspruch 1 gelöst.

Bei einer Struktur mit ersten Strukturelementen und zweiten Strukturelementen können eine Vielzahl von abwechselnd ersten Strukturelementen und zweiten Strukturelementen in einem Kanal vorgesehen sein, sodass Bereiche oder gegebenenfalls ein gesamter Kanal mit diesen Strukturelementen besetzt ist.

Durch die Anordnung der zweiten Strukturelemente in Lücken der ersten Strukturelemente wird zunächst eine laminare Strömung in einem Kanal oder allgemein innerhalb ein oder mehrerer Begrenzungen eines Kühlkörpers, beispielsweise dessen Wände, gezielt aufgebrochen, sodass es insbesondere zentral entlang der Strömungsrichtung zu einer guten Durchmischung innerhalb des Kühlmediums und damit letztlich auch zu einem guten Wärmeabtransport kommen kann, da die Wärme über die Begrenzungen ins Kühlmedium übertragen wird. Wenngleich nicht zwingend, ist es hierfür zweckmäßig, wenn die Lücken etwa zentral, beispielsweise auf einer Strömungsachse entlang eines Kanals, insbesondere entlang eines gerade verlaufenden Kanals, angeordnet sind. Die Anordnung "auf Lücke" ist somit bei Ausbildung des Kühlkörpers mit einer Längsachse auf der Längsachse oder bei Ausbildung mit nicht quadratischem oder rundem Querschnitt beispielsweise auf halber Höhe und/oder halber Breite eines Querschnittprofils zweckmäßig. Die ersten Strukturelemente und/oder die zweiten Strukturelemente sind zudem in Bereichen oder ganz verdrallt ausgebildet, sodass nicht nur ein Umlenken des andernfalls laminaren Stromes des Kühlmediums gegeben ist, sondern zugleich auch Turbulenzen generiert werden. Die Verdrallung kann sich über einen gesamten Bereich eines Strukturelementes ziehen, beispielsweise verdrallt aus einer Ebene senkrecht oder etwa senkrecht zur Strömungsrichtung. Jedenfalls sollte eine Verdrallung aber in den vom Zentrum weglaufenden Bereichen gegeben sein, sodass vom Zentrum zur Begrenzung hin Turbulenzen im Kühlmedium auftreten, wenn dieses den Kühlkörper durchströmt.

In einer Weiterbildung der Erfindung kann vorgesehen sein, dass seitliche Enden der ersten Strukturelemente und/oder der zweiten Strukturelemente an der Begrenzung schräg anschließen, um das Kühlmedium an der Begrenzung in Turbulenz zu versetzen. Wenngleich die Anordnung der Strukturelemente mit einer Abfolge von Lücken und keinen Lücken insbesondere im Zentrum und/oder zentrumsnah sowie die Verdrallung der Strukturelemente bzw. deren bereichsweise gebogene Ausbildung bereits für Umlenkung und Turbulenzen im Kühlmedium sorgt, stellt die gezielte Umlenkung des durchströmenden Kühlmediums im Bereich der Berührung der Strukturelemente mit der Begrenzung eine weitere Leistungssteigerung in Bezug auf die Kühlleistung sicher. Durch die entsprechende Maßnahme werden nämlich im Bereich der Begrenzung oder Begrenzungen zusätzliche Wirbel und damit noch mehr Turbulenz im Kühlmedium erzeugt. In dieser Weiterbildung sind somit drei verschiedene Aspekte gegeben:
- Eine quasi atmende Umlenkung des Hauptstromes entlang einer Zentralachse durch die Anordnung von Strukturelementen auf Lücke;
- vom Zentrum nach außen zu bzw. zu den Begrenzungen hin eine Induktion von Turbulenzen durch eine zumindest in Teilbereichen verdrallte bzw. gebogene Ausbildung von Strukturelementen;
- an der oder den Begrenzungen zusätzliche Wirbelbildung durch die schräge Anstellung der Strukturelemente an die Begrenzung(en).

Die Kombination der vorstehenden drei Aspekte bzw. Überlegungen für jeden einzelnen Teilquerschnittsbereich eines von einem Kühlmedium durchströmten Kühlkörpers ermöglicht eine hohe Kühlleistung, ohne dass ein hoher Druckabfall gegeben wäre.

Erfindungsgemäß liegen die ersten Strukturelemente und/oder die zweiten Strukturelemente in stirnseitiger Ansicht entlang der Strömungsrichtung in Form eines verdrallten X und eines nachgeordneten, vorzugsweise ebenfalls verdrallten, inversen X vor.

Die X-förmige Struktur kann dabei jeweils so ausgebildet sein, dass das Zentrum des X im Zentrumsbereich der Strömung des Kühlmediums liegt. Der Zentrumsbereich ist dabei abhängig von einem durch die Begrenzungen gebildeten Volumen des Kühlkörpers, in dem das Kühlmedium strömt. Bei Ausbildung des Kühlkörpers mit einem runden oder quadratischen oder anderen Querschnitt höherer Symmetrie wird die Strömungsachse mit den Zentren der X-Strukturen zusammenfallen. Bei einer niedrigeren Symmetrie des Querschnittes des Kühlkörpers, beispielsweise bei einer rechteckigen Ausbildung des Querschnittes, werden die Zentren der X-Strukturen in einer zentralen Strömungsebene des Kühlmediums auf halber Höhe des Querschnittes liegen.

Die ersten Strukturelemente und die zweiten Strukturelemente können abwechselnd angeordnet sein. Bevorzugt ist es, wie bereits erläutert, dass eine Vielzahl von ersten Strukturelementen und zweiten Strukturelementen jeweils abwechselnd vorgesehen sind. Die ersten Strukturelemente und die zweiten Strukturelemente können voneinander getrennt vorliegen. Insbesondere ist es nicht zwingend erforderlich, dass sich die ersten Strukturelemente und zweiten Strukturelemente berühren. Von Vorteil ist es jedoch, wenn die ersten Strukturelemente und die zweiten Strukturelemente miteinander verbunden sind. Insbesondere können die ersten Strukturelemente und die zweiten Strukturelemente integral miteinander, also mit ineinander übergehenden Bereichen, insbesondere auch einteilig, ausgebildet sein. Dies ist beispielsweise der Fall, wenn die Struktur mit den ersten Strukturelementen und zweiten Strukturelementen durch additive Fertigung wie 3-D-Druck erstellt wird.

Der Kühlkörper kann grundsätzlich eine beliebige Struktur aufweisen. Bevorzugt ist der Kühlkörper mit einer Längsachse ausgebildet, entlang welcher das Kühlmedium strömt. Mit anderen Worten: Der Kühlkörper weist eine Längserstreckung auf, die als Definition für eine Längsachse dient. Entlang dieser Längsachse befindet sich dann eine Hauptströmrichtung des Kühlmediums.

Der Kühlkörper weist eine oder gegebenenfalls mehrere Begrenzungen auf. Bei der oder den Begrenzungen handelt es sich in der Regel um jene außenseitigen Bereiche, welche zum inneren, durchströmbaren Volumen des Kühlkörpers hin begrenzen und über die ein Wärmeaustausch mit dem zu kühlenden Medium erfolgt. Insbesondere kann es sich bei der oder den Begrenzungen um die Wände eines Kanals handeln, in welchem das Kühlmedium strömt.

Ein erfindungsgemäßer Kühlkörper wird bevorzugt zur Kühlung eines elektronischen Schaltkreises oder Bauelementes eingesetzt. Ein Vorteil ist hierbei darin zu sehen, dass eine effiziente Kühlung bei minimiertem Druckabfall entlang einer Strömungsrichtung des Kühlmediums möglich ist.

In einem weiteren Aspekt ist ein erfindungsgemäßer Kühlkörper Teil einer Einrichtung, beispielsweise einer Datenverarbeitungseinrichtung oder Leistungselektronikkomponente.

Weitere Merkmale, Vorteile und Wirkungen der Erfindung ergeben sich aus den nachfolgenden Ausführungsbeispielen. In den Zeichnungen, auf welche dabei Bezug genommen wird, zeigen:
Fig. 1a einen Kühlkörper mit einer inneren Struktur mit einem X und einem inversen X;
Fig. 1b eine Simulation von Strömungsverhältnissen bei einer Struktur mit einem X und einem inversen X;
Fig. 2a eine schematische Darstellung der Verwirbelung eines Kühlmediums durch verdrillte bzw. verdrallte Teilbereiche einer Struktur;
Fig. 2b eine Simulation einer Strömung in einem Kanal mit verdrillten bzw. verdrallten Strukturen;
Fig. 3a eine schematische Darstellung der Auswirkung schräggestellter Teilbereiche einer Struktur;
Fig. 3b eine Simulation der Strömungsverhältnisse bei schräggestellten Bereichen einer Struktur;
Fig. 4a eine Seitenansicht eines Kühlkörpers mit einer Struktur mit mehreren Strukturelementen;
Fig.4b eine stirnseitige Ansicht des Kühlkörpers aus Fig. 4a;
Fig. 4c eine Draufsicht auf einen Kühlkörper gemäß Fig. 4a unter Erkenntlichmachung der inneren Struktur;
Fig. 4d eine perspektivische Ansicht des Kühlkörpers aus Fig. 4a;
Fig. 4e simulierte Strömungsverhältnisse in einem Kühlkörper gemäß Fig. 4a bis 4d;
Fig. 5a eine alternative Ausbildung eines Kühlkörpers;
Fig. 5b eine Seitenansicht des Kühlkörpers gemäß Fig. 5a;
Fig. 5c eine Draufsicht auf den Kühlkörper gemäß Fig. 4a unter Ersichtlichmachung der inneren Struktur;
Fig. 6 ein Diagramm zum Druckverlust in Relation zum hydraulischen Durchmesser für verschiedene Kühlkörper.

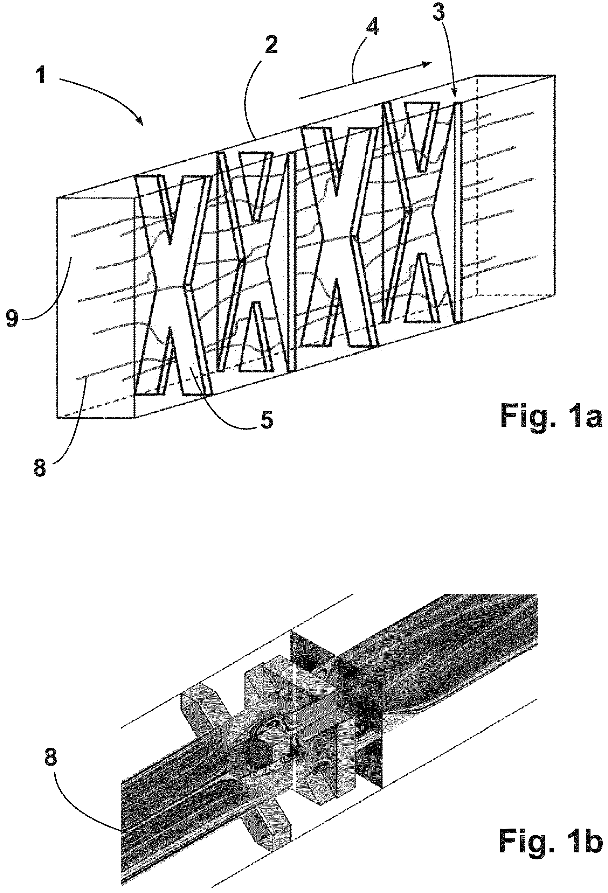

In Fig. 1a ist ein Ausschnitt aus einem Kühlkörper 1 schematisch dargestellt. Der Kühlkörper 1 weist eine schematisch angedeutete Begrenzung 2 auf, innerhalb welcher ein Kanal 9 gebildet ist, der ein durch die Begrenzung 2 vorgegebenes Volumen 3 aufweist. Im Inneren des Kanals 9 ist eine Struktur 5 angeordnet. Die Struktur 5 weist Strukturelemente auf. Die Strukturelemente sind im Wesentlichen X-förmig bzw. in Form eines inversen X ausgebildet. Invers bedeutet in diesem Fall, dass das Strukturelement in einer durch hier und im Folgenden durch einen Pfeil angedeuteten Strömungsrichtung 4 an jenen Stellen frei ist, welche sonst durch ein X belegt sind. Durch die Anordnung der Strukturelemente abwechselnd in Form eines X sowie eines inversen X kann ein Kühlmedium 8 in Strömungsrichtung 4 im Fluss gezielt gestört werden, sodass sich ein Strömungsmuster ergeben kann, wie dies in der Simulation in Fig. 1b gezeigt ist. Das Kühlmedium 8 passiert zunächst ein Strukturelement in Form eines X, wird dadurch umgelenkt und anschließend durch das nächste Strukturelement in Form eines inversen X gezwängt. Durch die wiederholten entsprechenden Umleitungen wird das in Strömungsrichtung 4 strömende Kühlmedium 8 sequenziell so umgelenkt, dass dieses quasi innerhalb des Kanals 9 atmet.

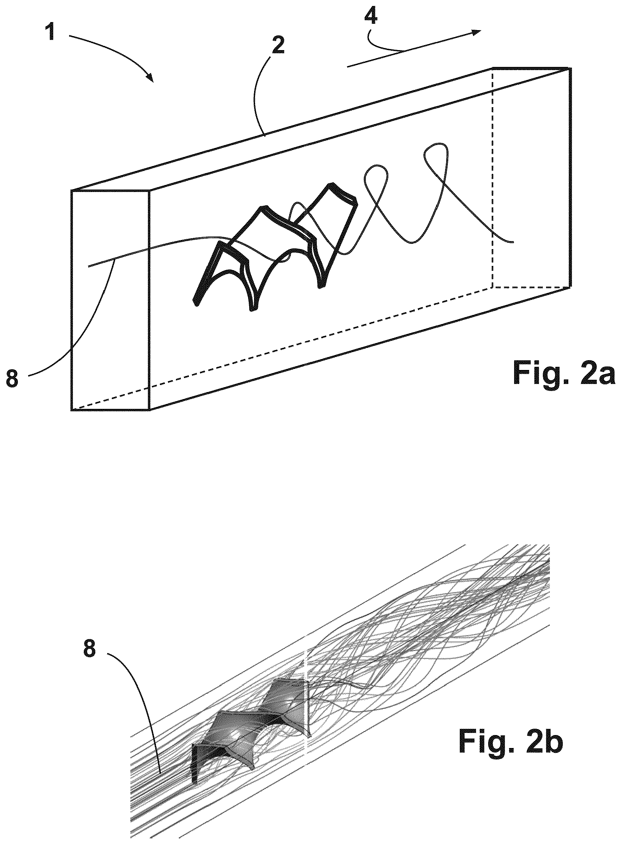

In Fig. 2a ist wiederum ein Kühlkörper 1 mit einem Strukturelement dargestellt. In diesem Fall handelt es sich um ein einziges Strukturelement, das in diesem Fall aber verdrallt ist, was dazu führt, wie in Fig. 2b ersichtlich ist, dass durchströmendes Kühlmedium 8 mit einem Drall beaufschlagt wird.

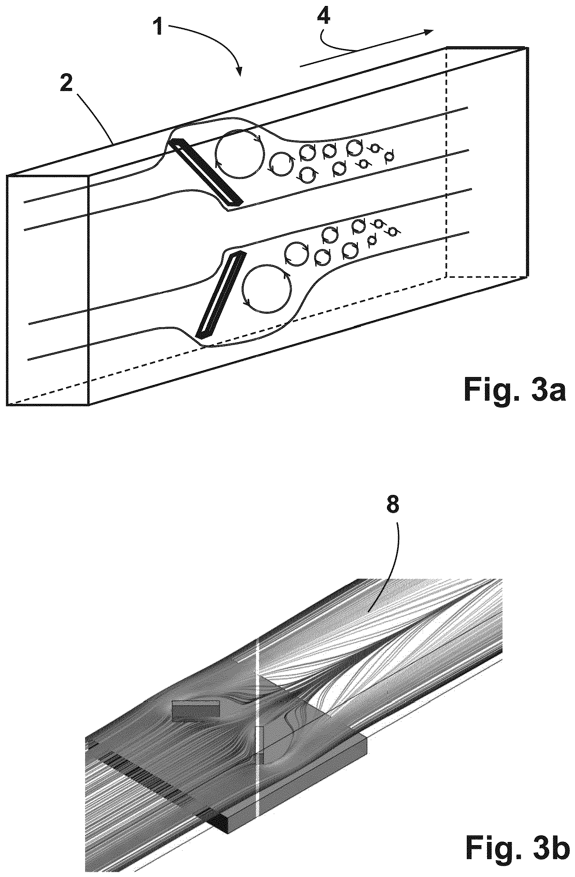

In Fig. 3a ist wiederum ein schematischer Kühlkörper 1 dargestellt, der von einem Kühlmedium 8 durchströmt wird. Im Kühlkörper 1 sind wiederum Strukturelemente angeordnet, in diesem Fall zwei zur Strömungsrichtung 4 des Kühlmediums 8 schräg angestellte Plättchen. Durch die Plättchen wird strömendes Kühlmedium 8 umgelenkt, sodass sich an der Rückseite der Plättchen Wirbel bilden. Eine entsprechende Simulation derartiger Wirbel, die sich beim strömenden Kühlmedium 8 entlang der Strömungsrichtung 4 im Kühlkörper 1 bilden, sind in Fig. 3b ersichtlich.

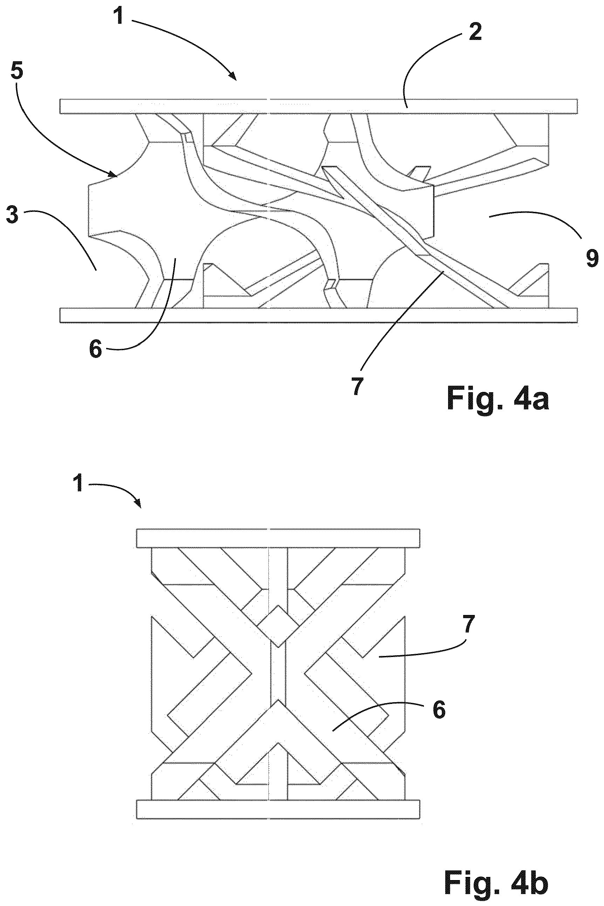

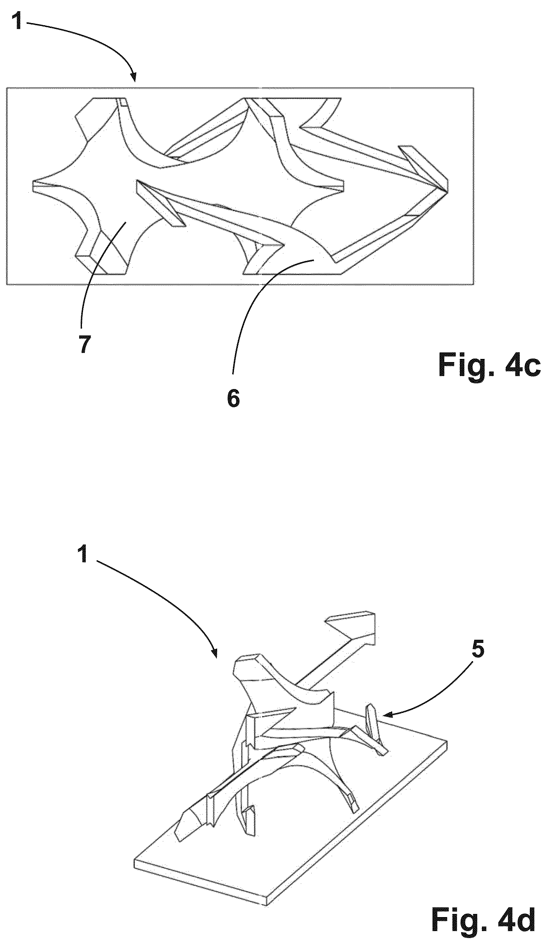

In Fig. 4a bis Fig. 4d ist ein erfindungsgemäßer Kühlkörper 1 in verschiedenen Ansichten ersichtlich. Der Kühlkörper 1 ist wiederum von einer Begrenzung 2 bzw. mehreren Wänden umgeben, welche ein Volumen 3 innerhalb des Kühlkörpers 1 definieren. Ein Kühlmedium 8 kann stirnseitig über eine Öffnung des Kühlkörpers 1 einströmen und über einen gegenüberliegenden Auslass abströmen. Der Kühlkörper 1 weist eine Struktur 5 auf, die im Inneren des Kühlkörpers 1 angeordnet ist. Die Struktur 5 umfasst ein erstes Strukturelement 6 und ein zweites Strukturelement 7. Bei diesen Strukturelementen sind die anhand von Fig. 1a, Fig. 2a und Fig. 3a erläuterten Möglichkeiten der Einbringung von Verwirbelung bzw. Turbulenz in das durchströmende Kühlmedium 8, und damit eine Maximierung einer Kühlleistung, allesamt realisiert. Das erste Strukturelement 6 ist von einem X abgeleitet, gleichzeitig aber verdrallt ausgebildet, sodass die für Fig. 1a und Fig. 2a erläuterten Effekte realisiert sind bzw. realisiert werden können. Darüber hinaus sind Bereiche der ersten Strukturelemente 6 sowie der zweiten Strukturelemente 7, welche an die Begrenzungen 2 bzw. Wände anschließen relativ zur Strömungsrichtung 4 schräg angestellt, sodass sich auch der Effekt gemäß Fig. 3a ergibt, also eine zusätzliche Wirbelbildung. Dies bringt den Vorteil, dass insbesondere im Bereich der Wände und damit letztlich in jenem Bereich, in dem am meisten gekühlt werden soll, die Kühlleistung maximiert wird. Somit sind mit den ersten Strukturelementen 6 und den abwechselnd mit diesen angeordneten zweiten Strukturelementen 7 drei Aspekte einer Wirbel- bzw. Turbulenzbildung im freien inneren Volumen 3 des Kühlkörpers 1 realisiert. Eine möglichst hohe Turbulenz sorgt für einen effektiven Wärmetransport und somit eine hohe Kühleistung.

Wie im Ausführungsbeispiel gemäß Fig. 4a bis Fig. 4d ersichtlich ist, erstrecken sich die ersten Strukturelemente 6 und die zweiten Strukturelemente 7 von der Begrenzung 2 weg bis in das Zentrum des Kühlkörpers 1. Des Weiteren sind die ersten Strukturelemente 6 mit den zweiten Strukturelementen 7 integral verbunden. Dies bedeutet, dass die ersten Strukturelemente 6 über eine Verdrallung in die zweiten Strukturelemente 7 übergehen, sodass eine kompakte Struktur 5 geschaffen ist. Möglich ist es aber auch, dass die ersten Strukturelemente 6 und die zweiten Strukturelemente 7 voneinander getrennt sind und aneinander nicht berühren.

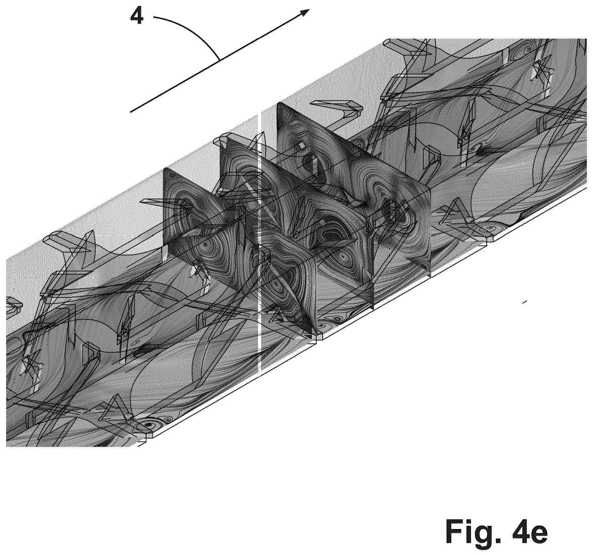

Mit der gewählten Ausbildung der ersten Strukturelemente 6 und der zweiten Strukturelemente 7 gemäß Fig. 4a bis Fig. 4d ist eine maximierte Kühlleistung möglich. Dies ist auf ein hohes Maß an Turbulenz zurückzuführen, die in Fig. 4e anhand eines Bildes aus einer Simulation dargestellt ist.

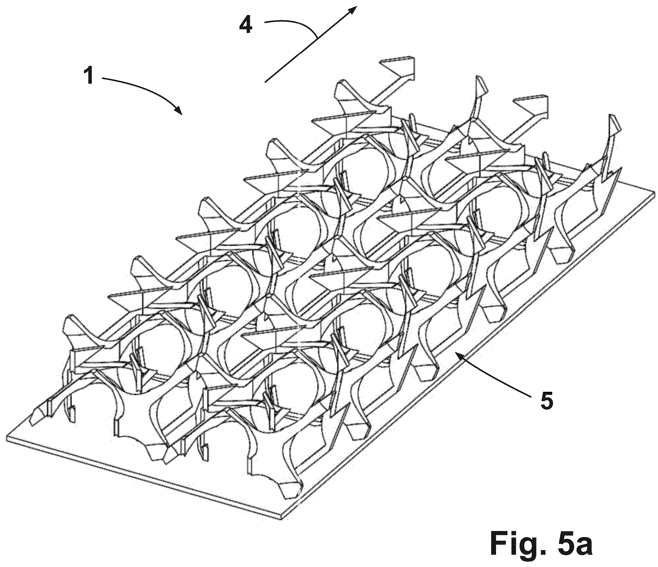

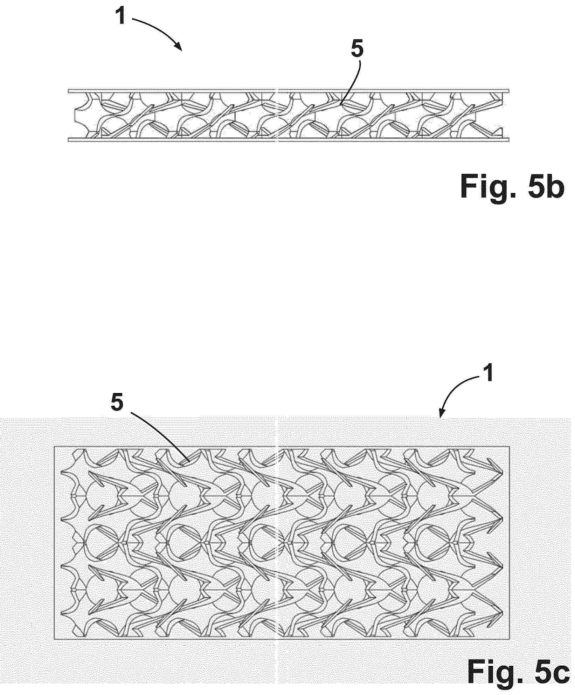

Die ersten Strukturelemente 6 und die zweiten Strukturelemente 7 können auch so gestaltet sein, dass sich diese nicht nur entlang eines Kanals 9, sondern bei einem Profil mit beispielsweise rechteckigem Querschnitt auch in die Breite bzw. über eine Breite eines Kühlkörpers 1 erstrecken. Dies ist für ein Ausführungsbeispiel in Fig. 5a bis Fig. c dargestellt.

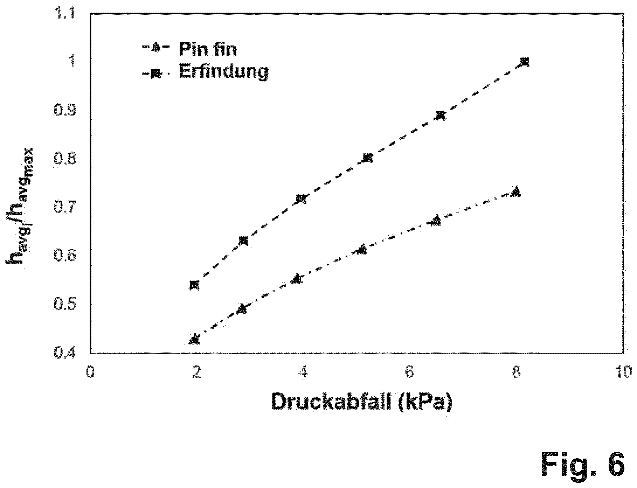

Die ersten Strukturelemente 6 und die zweiten Strukturelemente 7, die innerhalb des Kühlkörpers 1 bei strömenden Kühlmedium 8 für die gewünschte Verwirbelung und Turbulenzbildung sorgen, bedingen naturgemäß einen Druckabfall innerhalb des Kühlkörpers 1. Wie Fig. 6 zeigt, ist dieser Druckabfall aber deutlich geringer als bei herkömmlichen Ausbildungen von Kühlkörpern 1 mit einer Pin-Fin-Anordnung. Somit kann bei gleichzeitig erhöhter Kühlleistung auch ein Druckabfall minimiert werden.

## Patentansprüche

1. Kühlkörper (1), aufweisend eine oder mehrere Begrenzungen (2), welche ein Volumen (3) definieren, das von einem Kühlmedium (7) entlang einer Strömungsrichtung (4) durchströmbar ist, und zumindest eine im Volumen (3) angeordnete Struktur (5), welche ausgelegt ist, das Kühlmedium (7) beim Durchströmen des Volumens (3) umzulenken, wobei die Struktur (5) mit ersten Strukturelementen (6) und diesen nachfolgenden zweiten Strukturelementen (7) ausgebildet ist, wobei in Strömungsrichtung (4) betrachtet die zweiten Strukturelemente (7) zumindest bereichsweise in einer Lücke der ersten Strukturelemente (6) angeordnet sind und wobei die ersten Strukturelemente (6) und/oder die zweiten Strukturelemente (7) verdrallt ausgebildet sind, wobei die ersten Strukturelemente (6) in stirnseitiger Ansicht entlang der Strömungsrichtung (4) in Form eines verdrallten X vorliegen, **dadurch gekennzeichnet, dass** die zweiten Strukturelemente (7) in stirnseitiger Ansicht entlang der Strömungsrichtung in Form eines, den ersten Strukturelementen nachgeordneten, vorzugsweise ebenfalls verdrallten, inversen X vorliegen.

2. Kühlkörper (1) nach Anspruch 1, **dadurch gekennzeichnet, dass** seitliche Enden der ersten Strukturelemente (6) und/oder der zweiten Strukturelemente (7) an der Begrenzung (2) schräg anschließen, um das Kühlmedium (7) an der Begrenzung (2) in Turbulenz zu versetzen.

3. Kühlkörper (1) nach Anspruch 1 oder 2, **dadurch gekennzeichnet, dass** die ersten Strukturelemente (6) und die zweiten Strukturelemente (7) abwechselnd angeordnet sind.

4. Kühlkörper (1) nach einem der Ansprüche 1 bis 3, **dadurch gekennzeichnet, dass** die ersten Strukturelemente (6) und die zweiten Strukturelemente (7) miteinander verbunden sind.

5. Kühlkörper (1) nach Anspruch 4, **dadurch gekennzeichnet, dass** die ersten Strukturelemente (6) und die zweiten Strukturelemente (7) integral ausgebildet sind.

6. Kühlkörper (1) nach einem der Ansprüche 1 bis 5, **dadurch gekennzeichnet, dass** der Kühlkörper (1) mit einer Längsachse ausgebildet ist, entlang welcher das Kühlmedium (7) strömt.

7. Kühlkörper (1) nach einem der Ansprüche 1 bis 6, **dadurch gekennzeichnet, dass** zumindest eine Begrenzung (2) einen Kanal (8) definiert.

8. Einrichtung mit einem Kühlkörper (1) nach einem der Ansprüche 1 bis 7.

9. Verwendung eines Kühlkörpers (1) nach einem der Ansprüche 1 bis 7 zur Kühlung eines elektronischen Schaltkreises oder Bauelementes.

## Claims

1. A cooling element (1) having one or more boundaries (2) that define a volume (3), through which a cooling medium (7) can flow along a flow direction (4), and at least one structure (5) that is arranged in the volume (3) and designed for deflecting the cooling medium (7) while it flows through the volume (3), wherein the structure (5) is designed with first structural elements (6) and second structural elements (7) that follow the first structural elements, wherein the second structural elements (7) are, viewed in the flow direction (4), at least in certain areas arranged in a gap of the first structural elements (6), wherein the first structural elements (6) and/or the second structural elements (7) are designed in a twisted manner, and wherein the first structural elements (6) are, in a front view along the flow direction (4), realized in the form of a twisted X, **characterized in that** the second structural elements (7) are, in a front view along the flow direction, realized in the form of an inverse X that is arranged downstream of the first structural elements and preferably also twisted.

2. The cooling element (1) according to claim 1, **characterized in that** lateral ends of the first structural elements (6) and/or the second structural elements (7) are obliquely connected to the boundary (2) in order to cause turbulence of the cooling medium (7) on the boundary (2).

3. The cooling element (1) according to claim 1 or 2, **characterized in that** the first structural elements (6) and the second structural elements (7) are arranged alternately.

4. The cooling element (1) according to one of claims 1 to 3, **characterized in that** the first structural elements (6) and the second structural elements (7) are connected to one another.

5. The cooling element (1) according to claim 4, **characterized in that** the first structural elements (6) and the second structural elements (7) are designed integrally.

6. The cooling element (1) according to one of claims 1 to 5, **characterized in that** the cooling element (1) is designed with a longitudinal axis, along which the cooling medium (7) flows.

7. The cooling element (1) according to one of claims 1 to 6, **characterized in that** at least one boundary (2) defines a channel (8).

8. A device with a cooling element (1) according to one of claims 1 to 7.

9. The use of a cooling element (1) according to one of claims 1 to 7 for cooling an electronic circuit or component.

## Revendications

1. Dissipateur thermique (1) comportant une ou plusieurs délimitations (2), lesquelles définissent un volume (3), qui peut être traversé par un agent de refroidissement (7) le long d'une direction d'écoulement (4), et au moins une structure (5) disposée dans le volume (3), laquelle est conçue pour dévier l'agent de refroidissement (7) lors de la traversée du volume (3), sachant que la structure (5)est constituée avec des premiers éléments structuraux (6) et des deuxièmes éléments structuraux suivant ceux-ci (7), sachant que vues dans la direction d'écoulement (4), les deuxièmes éléments structuraux (7) sont disposés au moins par endroits dans un vide des premiers éléments structuraux (6) et sachant que les premiers éléments structuraux (6) et/ou les deuxièmes éléments structuraux (7) sont constitués torsadés, sachant que les premiers éléments structuraux (6) se présentent en vue de face le long de la direction d'écoulement (4) sous la forme d'un X torsadé, **caractérisé en ce que** les deuxièmes éléments structuraux (7) en vue de face le long de la direction d'écoulement se présentent de préférence également torsadés sous la forme d'un X inversé, disposés en aval des premiers éléments structuraux.

2. Dissipateur thermique (1) selon la revendication 1, **caractérisé en ce que** les extrémités latérales des premiers éléments structuraux (6) et/ou des deuxièmes éléments structuraux (7) se raccordent en diagonale à la délimitation (2) pour mettre en turbulence l'agent de refroidissement (7) sur la délimitation (2).

3. Dissipateur thermique (1) selon la revendication 1 ou 2, **caractérisé en ce que** les premiers éléments structuraux (6) et les deuxièmes éléments structuraux (7) sont disposés en alternance.

4. Dissipateur thermique (1) selon l'une quelconque des revendications 1 à 3, **caractérisé en ce que** les premiers éléments structuraux (6) et les deuxièmes éléments structuraux (7) sont reliés entre eux.

5. Dissipateur thermique (1) selon la revendication 4, **caractérisé en ce que** les premiers éléments structuraux (6) et les deuxièmes éléments structuraux (7) sont constitués de façon intégrale.

6. Dissipateur thermique (1) selon l'une quelconque des revendications 1 à 5, **caractérisé en ce que** le dissipateur thermique (1) est constitué d'un axe longitudinal le long duquel s'écoule le l'agent de refroidissement (7).

7. Dissipateur thermique (1) selon l'une quelconque des revendications 1 à 6, **caractérisé en ce qu'**au moins une délimitation (2) définit un conduit (8).

8. Dispositif avec un dissipateur thermique (1) selon l'une quelconque des revendications 1 à 7.

9. Utilisation d'un dissipateur thermique (1) selon l'une quelconque des revendications 1 à 7 pour le refroidissement d'un circuit ou d'un composant électronique.
